(19) Europäisches Patentamt / European Patent Office / Office européen des brevets

(11) **EP 2 478 599 B1**

(12) **EUROPÄISCHE PATENTSCHRIFT**

(45) Veröffentlichungstag und Bekanntmachung des Hinweises auf die Patenterteilung:
**06.09.2017 Patentblatt 2017/36**

(21) Anmeldenummer: **10759845.0**

(22) Anmeldetag: **16.09.2010**

(51) Int Cl.:
*H01S 5/14* *(2006.01)*       *H01S 3/067* *(2006.01)*
*H01S 3/083* *(2006.01)*       *H01S 3/106* *(2006.01)*
*G01N 21/00* *(2006.01)*       *H01S 3/11* *(2006.01)*

(86) Internationale Anmeldenummer:
**PCT/EP2010/063633**

(87) Internationale Veröffentlichungsnummer:
**WO 2011/033031 (24.03.2011 Gazette 2011/12)**

(54) **WELLENLÄNGENABSTIMMBARE LICHTQUELLE**

TUNABLE WAVELENGTH LIGHT SOURCE

SOURCE LUMINEUSE ACCORDABLE EN LONGUEUR D'ONDE

(84) Benannte Vertragsstaaten:
**AL AT BE BG CH CY CZ DE DK EE ES FI FR GB GR HR HU IE IS IT LI LT LU LV MC MK MT NL NO PL PT RO SE SI SK SM TR**

(30) Priorität: **18.09.2009 DE 102009042207**

(43) Veröffentlichungstag der Anmeldung:
**25.07.2012 Patentblatt 2012/30**

(73) Patentinhaber: **Ludwig-Maximilians-Universität München**
**80539 München (DE)**

(72) Erfinder:
• **HUBER, Robert, Alexander**
**83530 Schnaitsee (DE)**
• **KLEIN, Thomas**
**80335 München (DE)**
• **WIESER, Wolfgang**
**80687 München (DE)**

(74) Vertreter: **Lucke, Andreas et al**
**Boehmert & Boehmert**
**Anwaltspartnerschaft mbB**
**Pettenkoferstrasse 22**
**80336 München (DE)**

(56) Entgegenhaltungen:
**EP-A1- 1 139 521          EP-A2- 1 271 194**
**DE-A1- 19 926 299       US-A1- 2005 041 702**
**US-A1- 2009 219 959**

• **PALTE G ET AL: "Fourier domain mode locked (FDML) lasers for polarization sensitive OCT", PROCEEDINGS OF THE SPIE - THE INTERNATIONAL SOCIETY FOR OPTICAL ENGINEERING SPIE - THE INTERNATIONAL SOCIETY FOR OPTICAL ENGINEERING USA, Bd. 7372, 17. Juni 2009 (2009-06-17), XP002613475, ISSN: 0277-786X**
• **BIEDERMANN B R ET AL: "Dispersion, coherence and noise of Fourier domain mode locked lasers", OPTICS EXPRESS OPTICAL SOCIETY OF AMERICA USA, Bd. 17, Nr. 12, 29. Mai 2009 (2009-05-29), Seiten 9947-9961, XP002613476, ISSN: 1094-4087**

**Beschreibung**

Es wird eine wellenlängenabstimmbare Lichtquelle angegeben.

In der Druckschrift US 2006/187537 A1 ist eine Vorrichtung und ein Verfahren zur Modenkopplung angegeben.

Die Druckschrift US 5,077,815 betrifft eine Vorrichtung zur optischen Verbindung einer Monomodenfaser mit einer Multimodenfaser.

Ein Lichtwellenübertragungssystem, das ausgewählte optische Moden benützt, ist in der Druckschrift US 5,416,862 beschrieben.

Einen wellenlängenabstimmbaren Laser betrifft die Druckschrift WO 2008/135034 A1.

EP 1 271 194 A2 offenbart einen abstimmbaren Ramanfaserlaser. Zur Wellenlängenabstimmung wird ein abstimmbarer Bandpassfilter in den Resonator eingebracht, der eine Faser umfasst in der nur wenige Moden geführt werden.

DE 199 26 299 A1 offenbart einen Aufkonversionsfaserlaser der eine Faser umfasst, die so dimensioniert ist, dass bei der Pumpwellenlänge mehrere Moden geführt werden, bei der Laserwellenlänge jedoch nur die Grundmode und die erste höhere Mode geführt werden. Mittels eines dispersiven optischen Elements kann die Wellenlänge abgestimmt und Lasertätigkeit bei der Grundmode unterdrückt werden.

PALTE G ET AL: "Fourier domain mode locked (FDML) lasers for polarization sensitive OCT", PROCEEDINGS OF THE SPIE, Bd. 7372, 17. Juni 2009 offenbart einen FDML-Laser der einen faserbasierten Ringlaser mit einer 1.7 km langen Verzögerungsstrecke aufweist. Dem Laser ist eine externer Puffer nachgeschaltet der eine 0.85 km lange Verzögerungsstrecke aufweist zu der eine Überbrückungsstrecke optisch parallel geschaltet ist. Beide Verzögerungsstrecken sind durch Monomodenfasern gebildet.

Eine zu lösende Aufgabe besteht darin, eine wellenlängenabstimmbare Lichtquelle mit einer Oligomodenfaser anzugeben, wobei die Lichtquelle eine hohe Effizienz aufzeigt.

Diese Aufgabe wird erfindungsgemäß durch eine Lichtquelle gemäß Anspruch 1 gelöst.

Gemäß zumindest einer Ausführungsform der Lichtquelle ist diese wellenlängenabstimmbar und/oder wellenlängenveränderlich. Mit anderen Worten ist eine Wellenlänge und/oder spektrale Zusammensetzung einer von der Lichtquelle emittierten Strahlung im Betrieb nicht konstant, sondern unterliegt einer gezielten zeitlichen Änderung.

Gemäß zumindest einer Ausführungsform der Lichtquelle umfasst diese eine oder mehrere Faser-basierte Teilstrecken. Mit anderen Worten basieren die eine oder die mehreren Teilstrecken auf einem Lichtleiter, beispielsweise auf einer Glasfaser. Insbesondere ist eine Teilstrecke ein zusammenhängendes und/oder ununterbrochenes Stück eines Lichtleiters, insbesondere genau eines einzigen Lichtleiters. Gemäß zumindest einer Ausführungsform der Lichtquelle beinhaltet diese eine oder mehrere Verzögerungsstrecken. Die Verzögerungsstrecken sind dazu eingerichtet, über ihre optische Länge eine zeitliche Verzögerung eines die Verzögerungsstrecken durchlaufenden Lichts hervorzurufen. Insbesondere ist die eine oder sind die mehreren Verzögerungsstrecken passive Elemente. Mit anderen Worten ist es möglich, dass in der mindestens einen Verzögerungsstrecke keine optische Verstärkung und keine spektrale Filterung sowie kein Einschalten oder Ausschalten einer von der Lichtquelle erzeugten Strahlung erfolgt.

Gemäß zumindest einer Ausführungsform der Lichtquelle wird in der Verzögerungsstrecke insbesondere durch stimulierte Raman-Streuung eine Verstärkung erreicht.

Gemäß zumindest einer Ausführungsform der Lichtquelle gilt für eine Wellenlänge $\lambda$ zumindest eines Anteils der von der Lichtquelle emittierten Strahlung in Abhängigkeit von der Zeit t der folgende Zusammenhang:

$$\lambda(t) = \lambda(t - \tau).$$

$\tau$ ist hierbei eine feste Zeitspanne. Das heißt, dass die Lichtquelle zu einer bestimmten Zeit einen Lichtimpuls oder einen optischen Wellenzug mit einer bestimmten spektralen Signatur emittiert und nach der Zeitspanne $\tau$ eine Kopie oder ein Duplikat dieses Lichtimpulses emittiert. Mit anderen Worten erfolgt eine Wellenlängenabstimmung periodisch oder teilperiodisch.

Gemäß zumindest einer Ausführungsform der Lichtquelle ist die Verzögerungsstrecke teilweise oder, bevorzugt, vollständig mit einer oder mit mehreren Oligomodenfasern gebildet. Mit anderen Worten umfasst die Verzögerungsstrecke eine Oligomodenfaser oder besteht aus einer solchen. Das heißt, die Verzögerungsstrecke ist wenigstens stellenweise nicht durch eine Monomodenfaser, englisch single mode fiber oder kurz SMF, und auch nicht durch eine Multimodenfaser gebildet, die insbesondere Hunderte von Moden führt, wie zum Beispiel Fasern mit einem Kerndurchmesser von 50 $\mu$m oder 62,5 $\mu$m. Dies gilt insbesondere für den Spektralbereich, in dem die Lichtquelle im Betrieb Strahlung emittiert. Bevorzugt basiert die Verzögerungsstrecke vollständig auf Lichtleitern wie Glasfasern. Es ist möglich, dass die Verzögerungsstrecke durch einen einzigen, unterbrochenen und/oder zusammenhängenden Lichtleiter, insbesondere die Oligomodenfaser, gebildet ist. Die Oligomodenfaser führt in einem Wellenlängenbereich der von der Lichtquelle im Betrieb emittierten Strahlung zwischen einschließlich zwei Moden und 20 Moden, bevorzugt zwischen einschließlich zwei Moden und 12 Moden, besonders bevorzugt zwischen einschließlich zwei Moden und fünf Moden. Unter einer Mode ist hierbei insbesondere ein bestimmtes Intensitätsprofil in der Faser, gesehen in einem Querschnitt, zu verstehen. Bei den Moden kann es sich also um räumlich transversale Moden handeln. Verschiedene Polarisationsrichtungen einer Mode sind nicht als eigene Moden zu zählen. Eine Zählung der Moden erfolgt zum Beispiel wie in der Druckschrift D. Gloge, Weakly Guiding Fibers, Applied Optics, Vol. 10, Issue 10, Seiten 2252 bis 2258, aus dem Jahr 1971, angegeben. Der Offenbarungsgehalt dieser Druckschrift hinsichtlich der Zählung der Moden wird hiermit durch Rückbezug aufgenommen.

Gemäß zumindest einer Ausführungsform der Lichtquelle bezeichnet Oligomodenfaser eine beispielsweise nach der Druckschrift "INTERNATIONAL TELECOMMUNICATION UNION" ITU-T G.652 spezifiziert Oligomodenfaser mit insbesondere zwischen einschließlich zwei und 20 Moden, insbesondere wenn die Lichtquelle in einem Spektralbereich zwischen einschließlich 980 nm und 1150 nm betrieben wird. Der Offenbarungsgehalt dieser Druckschrift hinsichtlich einer Spezifizierung der Faser wird hiermit durch Rückbezug aufgenommen. Beispiele für solche Oligomodenfasern sind die Fasertypen SMF28 der Firma Corning, Allwave ZWP der Firma OFS oder FutureGuide®-SM der Firma Fujikura.

Gemäß zumindest einer Ausführungsform der Lichtquelle bezeichnet Oligomodenfaser eine Monomodenfaser, wenn diese zumindest teilweise zum Betrieb im Wellenlängenbereich zwischen einschließlich 30% und kleiner 100% der so genannten Monomodengrenzwellenlänge, auch als Single Mode Cut-Off Wavelength bezeichnet, vorgesehen ist. Bevorzugt wird die Lichtquelle zwischen einschließlich 60% und kleiner 100%, besonders bevorzugt zwischen einschließlich 75% und kleiner 100%, bezogen auf die Monomodengrenzwellenlänge, betrieben.

Gemäß zumindest einer Ausführungsform der Lichtquelle bezeichnet Oligomodenfaser eine Glasfaser, deren Single Mode Cut-Off Wavelength nach ITU-T G.650, von April 1997, SERIES G: TRANSMISSION SYSTEMS AND MEDIA, DIGITAL SYSTEMS AND NETWORKS Transmission media characteristics - Optical fibre cables - DEFINITON AND TEST METHODS FOR THE RELEVANT PARAMETERS OF SINGLE MODE FIBRES ITU-T, spezifiziert ist und die zumindest teilweise unterhalb dieser Single Mode Cut-Off Wavelength betrieben wird.

In mindestens einer Ausführungsform der wellenlängenabstimmbaren oder wellenlängenveränderlichen Lichtquelle beinhaltet diese wenigstens eine Faser-basierte Teilstrecke und wenigstens eine Verzögerungsstrecke. Die Lichtquelle ist dazu eingerichtet, dass für eine Wellenlänge $\lambda$ zumindest eines Anteils einer von der Lichtquelle emittierten Strahlung in Abhängigkeit von der Zeit t der Zusammenhang $\lambda (t) = \lambda (t - \tau)$ gilt. $\tau$ ist hierbei eine bestimmte Zeitspanne größer als Null. Ferner umfasst die Verzögerungsstrecke eine oder mehrere Oligomodenfasern.

Im Zusammenhang mit der wellenlängenabstimmbaren Lichtquelle hat es sich überraschend herausgestellt, dass anstelle einer Monomodenfaser für eine Verzögerungsstrecke eine Oligomodenfaser eingesetzt werden kann. Insbesondere bei Fourier-Domänen modengekoppelten Lasern, englisch Fourier domain mode locked lasers oder kurz FDML-Lasern, ist im Allgemeinen eine besonders große Sorgfalt darauf zu verwenden, eine präzise zeitliche Abstimmung von spektralen Anteilen innerhalb einer Laufstrecke einer Strahlung zu gewährleisten.

Durch die Verwendung einer Oligomodenfaser anstelle einer Monomodenfaser könnte erwartet werden, dass eine Modendispersion in der Oligomodenfaser und hierdurch eine zeitliche Verschmierung der Strahlung in der Oligomodenfaser auftritt. Überraschenderweise tritt dieser Effekt allerdings nur verringert oder nicht auf. Eine mögliche Erklärung hierfür könnte sein, dass insbesondere im Spektralbereich um 1050 nm herkömmliche Lichtleiter, im Gegensatz zum Spektralbereich um 1300 nm, keinen Dispersionsnullpunkt bezüglich der Wellenlänge der Strahlung aufweisen. Durch den Mehrmodenbetrieb könnte in der Verzögerungsstrecke daher eine chromatische Dispersion reduziert sein, da die chromatische Dispersion und die Modendispersion einander teilweise oder vollständig kompensieren könnten.

Weiterhin weisen auf Fasern basierte Lichtquellen im Regelfall notwendigerweise zumindest stellenweise Monomodenfasern auf. Beispielsweise bei FDML-Lasern mit mindestens einem Faser-Fabry-Perot-Filter ist es notwendig, dass die Fasern an diesem Filter Monomodenfasern sind, um spektrale Seitenbänder zu unterdrücken. Aufgrund unterschiedlicher Kerndurchmesser der Monomodenfaser und der Oligomodenfaser wäre es zu erwarten, dass hohe Verluste bei der Ankopplung der Oligomodenfaser an die Monomodenfaser auftreten.

Überraschenderweise scheint allerdings der Fall zu sein, dass die bei der Kopplung der Oligomodenfaser an die Monomodenfaser auftretenden Verluste kompensiert oder überkompensiert werden dadurch, dass eine Dämpfung der Oligomodenfaser insbesondere im Spektralbereich um 1050 nm deutlich geringer ist als eine Dämpfung einer Monomodenfaser in diesem Wellenlängenbereich. Dies kann sich speziell dann signifikant auswirken, falls die Verzögerungsstrecke eine vergleichsweise große optische Länge aufweist.

Insbesondere wird die Lichtquelle vorzugsweise dann mit mindestens einer Oligomodenfaser betrieben oder umfasst die Lichtquelle dann eine Oligomodenfaser, wenn ein optischer Verlust, der durch ungleiche Dämpfungskonstanten für verschiedene im Betrieb in der Oligomodenfaser propagierende Moden bedingt ist, kleiner oder gleich einem Gewinn ist, wobei der Gewinn auf einen reduzierten Verlust aufgrund besserer Qualitätsmerkmale der Oligomodenfaser, im Vergleich zu einer Monomodenfaser bei der gleichen Wellenlänge, zurückzuführen ist.

Gemäß zumindest einer Ausführungsform der Lichtquelle gehen wenigstens 10 % der Zeitspanne $\tau$ auf eine optische Länge der Verzögerungsstrecke und/oder der Oligomodenfaser zurück. Mit anderen Worten trägt die Oligomodenfaser und/oder die Verzögerungsstrecke zu der zeitlichen Verzögerung zwischen dem Lichtimpuls und der Kopie oder des Duplikats dieses Lichtimpulses, die von der Lichtquelle emittiert werden, zu mindestens 10 % bei. Bevorzugt beträgt dieser Beitrag mindestens 20 %, insbesondere mindestens 40 %. Besonders bevorzugt geht die Zeitspanne $\tau$ im Wesentlichen vollständig auf die Oligomodenfaser und/oder die Verzögerungsstrecke zurück, also beispielsweise zu mindestens 90 % oder zu mindestens 95 %. Mit anderen Worten kann dann eine optische Länge der Oligomodenfaser und/oder der Verzögerungsstrecke eine optische Länge aller anderen Teile der Lichtquelle deutlich übersteigen.

Gemäß zumindest einer Ausführungsform der Lichtquelle beträgt ein Kerndurchmesser der Oligomodenfaser zwischen einschließlich 7,5 $\mu$m und 9,5 $\mu$m. Der Kerndurchmesser ist zum Beispiel bei einer Stufenindexfaser der Durchmesser oder der mittlere Durchmesser des Bereichs, der einen im Vergleich zu einem Mantel erhöhten Brechungsindex aufzeigt. Insbesondere im Falle einer Gradientindexfaser kann es sich bei dem Kerndurchmesser oder effektiven Kerndurchmesser auch um einen Modenfelddurchmesser oder um einen mittleren Modenfelddurchmesser handeln. Die optische Länge der Oligomodenfaser und/oder der Verzögerungsstrecke beträgt zwischen einschließlich 10 m und 100 km, insbesondere zwischen einschließlich 100 m und 30 km, bevorzugt zwischen einschließlich 200 m und 15 km. Die optische Länge ist insbesondere eine geometrische Länge der Oligomodenfaser und/oder der Verzögerungsstrecke, multipliziert mit dem effektiven Brechungsindex. Bevorzugt entspricht die Länge der Verzögerungsstrecke der Länge der Oligomodenfaser.

Gemäß zumindest einer Ausführungsform der Lichtquelle beträgt eine spektrale Breite eines Abstimmbereichs der im Betrieb emittierten Strahlung der Lichtquelle mindestens 5 nm, bevorzugt mindestens 20 nm, insbesondere mindestens 50 nm. Mit anderen Worten ist die von der Lichtquelle emittierte Wellenlänge der Strahlung über mindestens einen der genannten Bereiche hinweg abstimmbar, bevorzugt kontinuierlich abstimmbar.

Gemäß zumindest einer Ausführungsform der Lichtquelle ist der spektrale Abstimmbereich der emittierten Strahlung kleiner als 300 nm, insbesondere kleiner als 120 nm.

Gemäß zumindest einer Ausführungsform der Lichtquelle liegt ein Wellenlängenbereich der im Betrieb emittierten Strahlung zwischen einschließlich 950 nm und 1250 nm, insbesondere zwischen einschließlich 1000 nm und 1150 nm. Mit anderen Worten wird von der Lichtquelle überwiegend oder ausschließlich in dem genannten Spektralbereich Strahlung emittiert.

Gemäß zumindest einer Ausführungsform der Lichtquelle ist die Oligomodenfaser und/oder die Verzögerungsstrecke teilweise oder, bevorzugt, vollständig aufgerollt. Vollständig aufgerollt schließt hierbei nicht aus, dass ein im Vergleich zu einer Gesamtlänge der Oligomodenfaser und/oder der Verzögerungsstrecke vernachlässigbarer Teil, insbesondere ein Teil zu Verbindungszwecken, nicht aufgerollt ist. Beispielsweise sind also mehr als 90 %, insbesondere mehr als 98 % der Oligomodenfaser und/oder der Verzögerungsstrecke aufgerollt.

Gemäß zumindest einer Ausführungsform der Lichtquelle beträgt ein Biegeradius oder ein mittlerer Biegeradius der aufgerollten Oligomodenfaser und/oder der aufgerollten Verzögerungsstrecke mindestens 2 cm und höchstens 50 cm, insbesondere mindestens 5 cm und höchstens 25 cm. Mit anderen Worten ist die Verzögerungsstrecke und/oder die Oligomodenfaser vergleichsweise eng gebogen. Durch ein Einstellen des Biegeradius kann es ermöglicht sein, eine Modendispersion und/oder eine chromatische Dispersion der Verzögerungsstrecke und/oder der Oligomodenfaser zu beeinflussen. Entsprechendes kann für eine Polarisationsdispersion, eine Polarisationsrotation und/oder eine modenabhängige Dämpfung gelten. Bevorzugt können weiterhin durch kontrolliertes, insbesondere mechanisches Verspannen der Oligomodenfaser die Polarisationsdispersion, die Polarisationsrotation und/oder die modenabhängige Dämpfung gezielt beeinflusst werden.

Gemäß zumindest einer Ausführungsform der Lichtquelle umfasst die Verzögerungsstrecke mindestens zwei Spulen mit je einer Oligomodenfaser oder mit je mehreren Oligomodenfasern. Im Fall von zwei Spulen kann dies bedeuten, dass zwei verschiedene Träger vorhanden sind, auf denen je eine oder mehrere der Oligomodenfasern aufgerollt sind. Ebenso ist es möglich, dass die zwei Spulen über einen gemeinsamen Träger, beispielsweise eine Rolle, verfügen, jedoch die Oligomodenfasern der jeweiligen Spulen optisch und/oder funktionell voneinander getrennt sind. Funktionell getrennt kann bedeuten, dass unterschiedliche Strahlungsanteile unterschiedliche Lichtwege durch die Verzögerungsstrecke zurücklegen. Beispielsweise durchläuft ein Strahlungsanteil nur eine der Spulen und ein weiterer Strahlungsanteil alle oder mehrere der Spulen.

Gemäß zumindest einer Ausführungsform der Lichtquelle weisen die Spulen oder die Oligomodenfasern der jeweiligen Spulen voneinander verschiedene optische Längen auf. Bevorzugt sind die optischen Längen der einzelnen Spulen oder Oligomodenfasern insbesondere paarweise gezielt voneinander verschieden gestaltet.

Gemäß zumindest einer Ausführungsform der Lichtquelle gilt für die optische Länge $L_{opt}$ der Oligomodenfaser, mit einer Toleranz von höchstens 10 %, insbesondere von höchstens 2 % der Zusammenhang:

$$L_{opt} = c \ / \ (N \ \tau),$$

wobei c die Vakuumlichtgeschwindigkeit und N eine natürliche Zahl größer oder gleich 1 ist.

Gemäß zumindest einer Ausführungsform der Lichtquelle weist wenigstens eine der Spulen eine optische Länge auf, die ein ganzzahliges Vielfaches der optischen Länge der Spule beträgt, die die kleinste optische Länge aufweist. Insbesondere folgen die Längen dem Zusammenhang, dass die optische Länge $L_N$ der N-ten Spule gleich ist dem $2^N$-fachen der optischen Länge $L_0$ der Spule mit der kleinsten optischen Länge. N ist hierbei eine natürliche Zahl größer oder gleich 1.

Gemäß zumindest einer Ausführungsform der Lichtquelle sind Teile der Spulen gegenüber anderen Teilen der jeweiligen Spule gegeneinander verkippt angeordnet. Das kann bedeuten, dass durch eine oder mehrere Wicklungen der Spule eine erste Ebene definiert ist und durch eine oder mehrere andere Wicklungen derselben Spule eine zweite Ebene definierten ist. Die erste Ebene ist gegenüber der zweiten Ebene dann um einen Winkel verkippt. Bevorzugt beträgt der Winkel zwischen den Ebenen zwischen einschließlich 30° und 100°, insbesondere zwischen einschließlich 70° und 95°. Weiterhin kann eine oder jede der Spulen zwei oder mehr als zwei durch Wicklungen der Spule definierte Ebenen aufweisen, die gegeneinander verkippt angeordnet sind.

Gemäß zumindest einer Ausführungsform der Lichtquelle ist der Verzögerungsstrecke und/oder der Oligomodenfaser eine Überbrückungsstrecke optisch parallel geschaltet. Optisch parallel geschaltet kann bedeuten, dass die Verzögerungsstrecke und die Überbrückungsstrecke zwei durch einen Strahlteiler aufgespaltene Teilstrecken der Lichtquelle sind. Die Überbrückungsstrecke basiert bevorzugt auf einer Glasfaser.

Gemäß zumindest einer Ausführungsform der Lichtquelle ist eine optische Länge der Überbrückungsstrecke kleiner als die optische Länge der Verzögerungsstrecke. Bevorzugt ist die optische Länge der Überbrückungsstrecke gegenüber der optischen Länge der Verzögerungsstrecke vernachlässigbar. Vernachlässigbar kann bedeuten, dass die Länge der Überbrückungsstrecke höchstens 10 %, insbesondere höchstens 5 %, besonders bevorzugt höchstens 1 % der Länge der Verzögerungsstrecke beträgt.

Gemäß zumindest einer Ausführungsform der Lichtquelle ist eine Abstimmrate der im Betrieb von der Lichtquelle emittierten Strahlung mittels der Verzögerungsstrecke vervielfacht. Beispielsweise durchläuft eine Kopie oder ein Duplikat eines von der Lichtquelle emittierten Lichtimpulses einmal die Verzögerungsstrecke und wird erst nachfolgend ausgekoppelt, wobei der ursprüngliche, originale Lichtimpuls die Verzögerungsstrecke nicht durchläuft. Hierdurch ist die Abstimmrate der Lichtquelle verdoppelbar. Beim Einsatz beispielsweise von zwei Spulen und/oder einer zweigeteilten Verzögerungsstrecke ist die Abstimmrate vervierfachbar.

Gemäß zumindest einer Ausführungsform der Lichtquelle beträgt die Abstimmrate der Wellenlänge der emittierten Strahlung mindestens 1 kHz, insbesondere mindestens 10 kHz, bevorzugt mindestens 30 kHz oder mindestens 100 kHz. Die Zeitspanne $\tau$ beträgt dann bevorzugt höchstens 1 ms, insbesondere höchstens 100 μs oder höchstens 33 μs oder höchstens 10 μs. Mit anderen Worten ist die Wellenlänge, die von der Lichtquelle emittiert wird, schnell abstimmbar.

Gemäß zumindest einer Ausführungsform der Lichtquelle beträgt ein relativer Zeitanteil, in dem die Lichtquelle im Betrieb im Mittel die Strahlung emittiert, mindestens 1 %. Das heißt, die Lichtquelle ist dann insbesondere keine Kurzimpulslichtquelle, die nur in einem kurzen Zeitbereich, bezogen auf eine gesamte effektive Betriebszeit, Strahlung emittiert. So werden im Gegensatz hierzu etwa bei Lasern mit Repetitionsraten im Kilohertzbereich, die Nanosekundenlichtimpulse erzeugen oder bei Femtosekundenlichtquellen mit Repetitionsraten im Megahertzbereich nur zu einem vergleichsweise kleinen relativen Zeitanteil von zirka $10^{-6}$ Strahlung emittiert. In dem verbleibenden Zeitanteil wird bei solchen Lichtquellen im Rahmen der Betriebstoleranzen keine Strahlung emittiert.

Gemäß zumindest einer Ausführungsform der Lichtquelle ist die Verzögerungsstrecke und/oder die Oligomodenfaser dazu eingerichtet, von der im Betrieb emittierten Strahlung mindestens zweifach oder mindestens vierfach durchlaufen zu werden. Das heißt, die Verzögerungsstrecke und/oder die Oligomodenfaser wird von einem bestimmten Teil der Strahlung oder von der gesamten Strahlung mehrfach durchlaufen.

Gemäß zumindest einer Ausführungsform der Lichtquelle ist diese ein Laser. Das heißt, die von der Lichtquelle emittierte Strahlung kann eine kohärente Strahlung sein.

Gemäß zumindest einer Ausführungsform der Lichtquelle umfasst diese einen Resonator. Bei dem Resonator kann es sich um einen Laserresonator handeln.

Gemäß zumindest einer Ausführungsform der Lichtquelle ist die Verzögerungsstrecke und/oder die Oligomodenfaser oder eine der Oligomodenfasern von dem Resonator der Lichtquelle beinhaltet. Das heißt, die Verzögerungsstrecke und/oder die Oligomodenfaser ist dann ein Bestandteil des Resonators.

Gemäß zumindest einer Ausführungsform der Lichtquelle ist die Verzögerungsstrecke und/oder die Oligomodenfaser und/oder eine oder alle der Oligomodenfasern dem Resonator nachgeordnet. Mit anderen Worten ist es möglich, dass die Lichtquelle einen Resonator umfasst und dass die Verzögerungsstrecke außerhalb, in einer Strahlrichtung dem Resonator nachfolgend, platziert ist. In diesem Fall gelangt lediglich aus dem Resonator bereits ausgekoppelte Strahlung zu der Verzögerungsstrecke und/oder zu der Oligomodenfaser. Ebenso ist es möglich, dass die Verzögerungsstrecke und/oder die Oligomodenfaser allen anderen Teilstrecken der Lichtquellen oder allen Teilstrecken mit Ausnahme einer einzigen Teilstrecke in Strahlrichtung nachgeordnet ist.

Gemäß zumindest einer Ausführungsform der Lichtquelle sind, außer der Verzögerungsstrecke und/oder der Oligomodenfaser, alle Faser-basierten Teile des Resonators oder alle weiteren Teilstrecken der Lichtquelle mit Monomodenfasern gestaltet. Faser-basierte Teile sind zum Beispiel Faserverstärker, Polarisationskontrolleinheiten oder Faser-Fabry-Perot-Filter.

Gemäß zumindest einer Ausführungsform der Lichtquelle umfasst diese einen Amplitudenmodulator und/oder einen Phasenmodulator, der zum Abstimmen der Wellenlänge eingerichtet ist. Alternativ oder zusätzlich kann die Lichtquelle eine Stromquelle umfassen, die zu einer zeitlich veränderlichen Bestromung eingerichtet ist, wobei die Wellenlänge mindestens teilweise über die Bestromung einstellbar ist.

Gemäß zumindest einer Ausführungsform der Lichtquelle umfasst diese einen Kompensator, der mindestens ein optisches Element umfasst und der dazu eingerichtet ist, eine durch die Verzögerungsstrecke mit der Oligomodenfaser hervorgerufene chromatische Dispersion teilweise oder vollständig zu kompensieren. Bevorzugt ist mindestens ein solches optisches Elemente des Kompensators ein so genanntes gechirptes Faser-Bragg-Gitter, kurz cFBG oder englisch Chirped Fibre Bragg Grating. Das cFBG kann unmittelbar in der Oligomodenfaser erzeugt beziehungsweise geschrieben sein. Ebenso ist es möglich, dass das cFBG in einem Stück einer Monomodenfaser erzeugt ist, wobei dieses Stück insbesondere mittels eines Spleißes mit der Oligomodenfaser verbunden ist. Zur Kompensation von Beiträgen höherer Ordnung der chromatischen Dispersion, die durch die Oligomodenfaser hervorgerufen ist, können auch mehrere cFBGs eingesetzt werden. Die cFBGs sind zum Beispiel über einen so genannten 4-Port-Zirkulator miteinander verbunden.

Gemäß zumindest einer Ausführungsform der Lichtquelle umfasst diese eine spektral breitbandig emittierende Strahlungsquelle, die insbesondere keine kohärente Strahlung emittiert, und einen abstimmbaren optischen Bandpassfilter. Bevorzugt umfasst die Lichtquelle zwei oder mehr als zwei abstimmbare optische Bandpassfilter.

Gemäß zumindest einer Ausführungsform der Lichtquelle umfasst diese zu einer Wellenlängeneinstellung der zu emittierenden Strahlung ein mikro-elektromechanisches System, kurz MEMS.

Bei dem MEMS kann es sich um einen Fabry-Perot-artigen Filter handeln, beispielsweise wie in der Druckschrift US 2006/0072632 A1 oder in der Druckschrift "Single transverse mode optical resonators", Optics Express, Vol. 13, No. 1, Seiten 171 bis 181, vom 10. Januar 2005, angegeben. Der Offenbarungsgehalt dieser Druckschriften hinsichtlich des MEMS wird durch Rückbezug mit aufgenommen.

Gemäß zumindest einer Ausführungsform der Lichtquelle umfasst diese zu einer Wellenlängeneinstellung der zu emittierenden Strahlung einen rotierenden oder schnell winkelveränderlichen Spiegel, insbesondere einen Polygonspiegel. Eins solcher Spiegel ist zum Beispiel in der Druckschrift "High-speed wavelength-swept semiconductor laser with a polygon-scanner-based wavelength filter", Optics Letters, Vol. 28, No. 20, Seiten 1981 bis 1983, vom 15. Oktober 2003, angegeben. Der Offenbarungsgehalt dieser Druckschrift hinsichtlich des Spiegels wird durch Rückbezug mit aufgenommen.

Gemäß zumindest einer Ausführungsform der Lichtquelle verläuft die Strahlung innerhalb der Lichtquelle im Wesentlichen vollständig in kondensierter Materie, insbesondere in Feststoffen. Im Wesentlichen kann bedeuten, dass nur zum Beispiel Luftspalte an Fasersteckverbindungen oder an Fabry-Perot-Filtern vorliegen. Zum Beispiel liegen dann mindestens 99 % oder mindestens 99,9 % des Lichtweges in der Lichtquelle in kondensierter Materie.

Gemäß zumindest einer Ausführungsform der Lichtquelle ist diese ein Fourier-Domänen modengekoppelter Laser. Insbesondere ist die Lichtquelle dann zur optischen Kohärenztomografie eingerichtet.

Gemäß zumindest einer Ausführungsform der Lichtquelle ist diese zur optischen Datenübertragung eingerichtet. Die Lichtquelle umfasst dann bevorzugt mindestens eine Übertragungsstrecke, wobei die Übertragungsstrecke der Verzögerungsstrecke optisch parallel geschaltet ist oder die Verzögerungsstrecke gleichzeitig teilweise oder vollständig die Übertragungsstrecke bildet. Der Wellenlängenbereich der im Betrieb des Lasers erzeugten Strahlung ist von einem Übertragungswellenlängenbereich verschieden. Beispielsweise liegt die von der Lichtquelle emittierte Strahlung bei zirka 1050 nm und der Übertragungswellenlängenbereich ist um 1300 nm zentriert. Die Verzögerungsstrecke und die Übertragungsstrecke weisen, mit einer Toleranz von höchstens 1 %, gleiche optische Längen auf, bezogen auf den jeweils relevanten Spektralbereich. Ferner ist die Übertragungsstrecke im speziell bei größeren Wellenlängen liegenden Übertragungswellenlängenbereich eine Monomodenfaser.

Gemäß zumindest einer Ausführungsform der Lichtquelle, bei der diese zur optischen Datenübertragung eingerichtet ist, liegt ein Wellenlängenabstimmbereich der emittierten Strahlung zwischen einschließlich 10 MHz und 100 GHz. Der Wellenlängenabstimmbereich ist dann vergleichsweise schmal.

Die Lichtquelle kann zur Erzeugung zeitlich wellenlängenveränderlicher Strahlung verwendet werden, insbesondere zu Abbildungsaufgaben, Messaufgaben, zur Informationsübertragung, zur Sensorik und zur Profilometrie.

Nachfolgend wird eine hier beschriebene Lichtquelle unter Bezugnahme auf die Zeichnung anhand von Ausführungsbeispielen näher erläutert. Gleiche Bezugszeichen geben dabei gleiche Elemente in den einzelnen Figuren an. Es sind dabei jedoch keine maßstäblichen Bezüge dargestellt, vielmehr können einzelne Elemente zum besseren Verständnis übertrieben groß dargestellt sein.

Es zeigen:

| Figuren 1, 4, 5, 7, 9 und 10 | schematische Darstellungen von Ausführungsbeispielen von hier beschriebenen wellenlängenabstimmbaren Lichtquellen, |
| --- | --- |
| Figuren 2 und 3 | schematische Darstellungen zur Charakterisierung einer von hier beschriebenen Lichtquellen emittierten Strahlung, |
| Figur 6 | eine schematische Darstellung einer Vervielfachung der Abstimmrate bei einer hier beschriebenen Lichtquelle, und |
| Figur 8 | eine schematische Illustration der Modendispersion in einer Oligomodenfaser. |

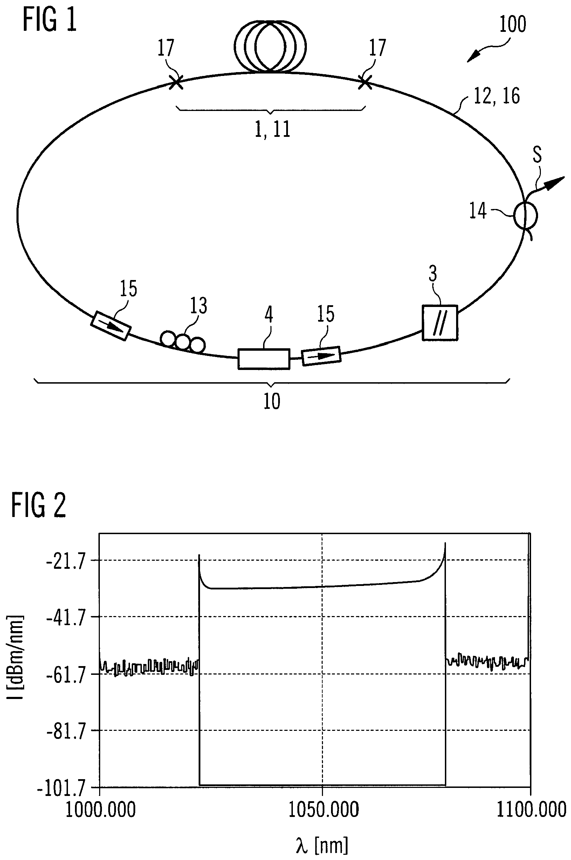

In Figur 1 ist ein schematischer Aufbau einer hier beschriebenen Lichtquelle 100 illustriert. Die Lichtquelle 100 gemäß Figur 1 ist ein Fourier-Domänen modengekoppelter Laser, beispielsweise zur optischen Kohärenztomografie.

Ein optisches Verstärkungsmedium 4 ist zum Beispiel ein optischer Halbleiterverstärker, englisch semiconductor optical amplifier oder kurz SOA. Als Verstärkungsmedium 4 kann alternativ oder zusätzlich ein Faserverstärker eingesetzt sein. Eine Wellenlängenselektion erfolgt über einen abstimmbaren optischen Filter 3. Zum Beispiel ist der optische Filter 3 ein Faser-Fabry-Perot-Filter. Dem Filter 3 ist in einer Umlaufrichtung ein Faserkoppler 14 nachgeordnet. Über den Faserkoppler werden beispielsweise 30 % der Lichtintensität ausgekoppelt. Eine an dem Faserkoppler 14 ausgekoppelte Strahlung S wird von der Lichtquelle 100 emittiert.

Ferner beinhaltet die Lichtquelle 100 eine Verzögerungsstrecke 1, die vollständig durch eine Oligomodenfaser 11 gebildet ist. Die Verzögerungsstrecke 1 ist über Spleiße 17 in einen Resonator 10 der Lichtquelle 100, der die weiteren Bestandteile der Lichtquelle 100 beinhaltet, eingebaut. Ein Übergang der Monomodenfaser 16 zu der Oligomodenfaser 11 kann auch über Steckverbindungen erfolgen. Die Verzögerungsstrecke ist etwa durch eine Faser des Typs SMF 28 der Firma Corning oder durch eine Faser des Typs Allwave ZWP der Firma OFS gebildet. Die Oligomodenfaser 11 hat zum Beispiel eine geometrische Länge von zirka 3,5 km, entsprechend einer optischen Länge von zirka 5,14 km bei einem Brechungsindex der Faser von 1,468.

Alle anderen Faser-basierten Teile des Resonators 10, also alle Faser-basierten Teile außer der Verzögerungsstrecke 1, sind durch Monomodenfasern 16 realisiert. Bei den Monomodenfasern 16 handelt es sich insbesondere um Fasern des Typs HI 1060 der Firma Corning.

Die Verzögerungsstrecke 1 und somit die Oligomodenfaser 11 sind auf eine Spule mit einem Durchmesser von zirka 30 cm vollständig aufgewickelt. Durch eine Einstellung des Krümmungsradiusses der Spule kann eine Ausdämpfung unerwünschter Moden bestimmter Ordnung realisierbar sein.

Durch eine gezielte räumliche Orientierung relativ zu einer Krümmungsachse der Spule oder von Teilen der Spule und der Oligomodenfaser 11 ist es ferner möglich, Verluste von Moden höherer Ordnungen zu kontrollieren.

Ferner beinhaltet der Resonator 10 eine Polarisationskontrolleinheit 13 sowie optional einen oder mehrere optische Isolatoren 15. Eine Durchlassrichtung der Isolatoren 15 ist in Figur 1 durch Pfeile angedeutet. Die Reihenfolgen der Komponenten der Lichtquelle 100, wie in Figur 1 illustriert, kann permutiert sein.

In Figur 2 ist ein Spektrum der von der gemäß Figur 1 aufgebauten Lichtquelle 100 dargestellt. Es ist eine wellenlängenabhängige Intensität I in dB gegenüber der Wellenlänge $\lambda$ der Strahlung S in nm aufgetragen. Die Strahlung S ist um 1050 nm zentriert. Ein Durchstimmbereich der Strahlung beträgt zirka 57 nm. Mit anderen Worten kann von der Lichtquelle 100 im Spektralbereich von zirka 1025 nm bis zirka 1080 nm Strahlung emittiert werden. Eine Durchstimmung der Strahlung erfolgt über 2 x 53867 bidirektionale Wellenlängendurchläufe in dem Resonator 10 pro Sekunde. Eine Zeitabhängigkeit der Wellenlänge $\lambda$ der Strahlung S kann sinusartig oder sägezahnartig gestaltet sein.

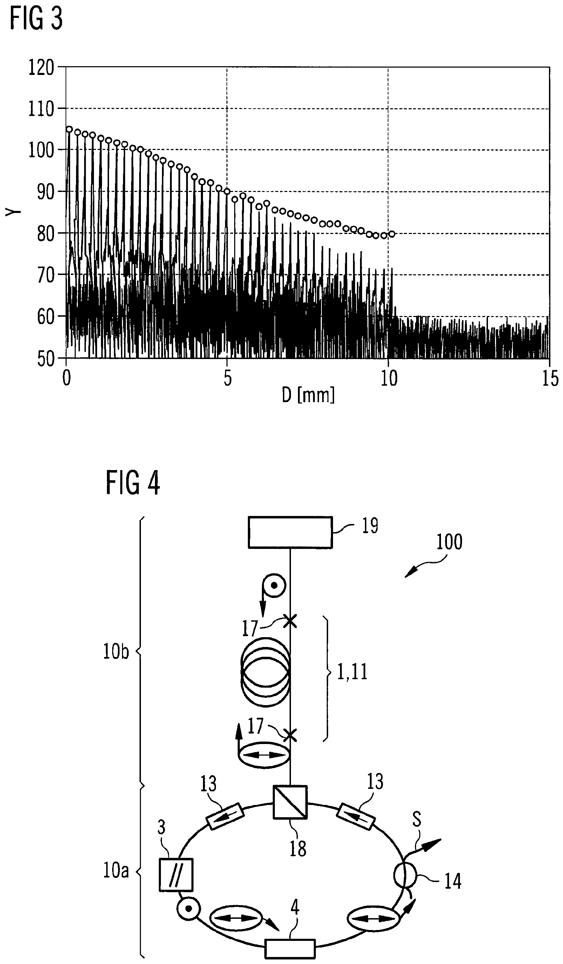

In Figur 3 ist eine Amplitude eines mit einer Fotodiode detektierten Interferenzsignals Y der Strahlung S, die über ein Mach-Zehnder-Interferometer geführt wurde, dargestellt. Die vertikalen Linien in Figur 3 geben hierbei eine Fouriertransformierte des Interferenzsignals Y an. Als Abszisse ist die Weglängendifferenz D zwischen Interferometerarmen des Interferometers in mm dargestellt. Das Interferenzsignal Y ist in beliebigen Einheiten logarithmisch gegenüber dem Weglängenunterschied D aufgetragen.

Aus Figur 3 ist ersichtlich, dass mindestens bis zu einer Weglängendifferenz D von zirka 10 mm noch ein deutliches Interferenzsignal Y detektierbar ist. Eine Kohärenzlänge, eine Auflösung und ein Dynamikbereich der Strahlung S der Lichtquelle 100 sind hiernach zum Einsatz für optische Kohärenztomografie beispielsweise am menschlichen Auge geeignet.

In Figur 4 ist ein weiteres Ausführungsbeispiel der Lichtquelle 100 illustriert. Die Lichtquelle 100 weist einen Resonatorteil 10a auf, in dem sich das Verstärkungsmedium 4 sowie der Filter 3 befinden. Über einen polarisationsabhängig reflektierenden Strahlteiler 18 ist der Resonatorteil 10a mit einem Resonatorteil 10b verbunden oder an diesen gekoppelt. Anstelle des Strahlteilers 18 kann auch ein optischer Zirkulator, ein polarisationsunabhängiger, als teildurchlässiger Spiegel ausgebildeter Strahlteiler oder ein Faserkoppler verwendet werden. In dem Resonatorteil 10b befindet sich die über die Spleiße 17 eingebaute Verzögerungsstrecke 1 mit der Oligomodenfaser 11. An einer dem polarisationsabhängig reflektierenden Strahlteiler 18 abgewandten Seite des Resonatorteils 10b befindet sich ein Faraday-Spiegel 19. Über den Faraday-Spiegel 19 erfolgt bei Reflexion eine Polarisationsdrehung der in dem Resonator 10a, 10b umlaufenden Strahlung. Eine Polarisationsrichtung der Strahlung sowie die Laufrichtung der Strahlung sind durch Pfeile und Punkte symbolisiert. Die mit der Oligomodenfaser 11 gebildete Verzögerungsstrecke 1 wird von der im Resonator 10a, 10b umlaufenden Strahlung zweifach durchlaufen. Die in Figur 4 illustrierte Lichtquelle kann analog zu dem in der Druckschrift WO 2008/135034 A1 angegebenen Lichtquellen aufgebaut sein. Der Offenbarungsgehalt dieser Druckschrift hinsichtlich der angegebenen Lichtquellen wird hiermit durch Rückbezug aufgenommen.

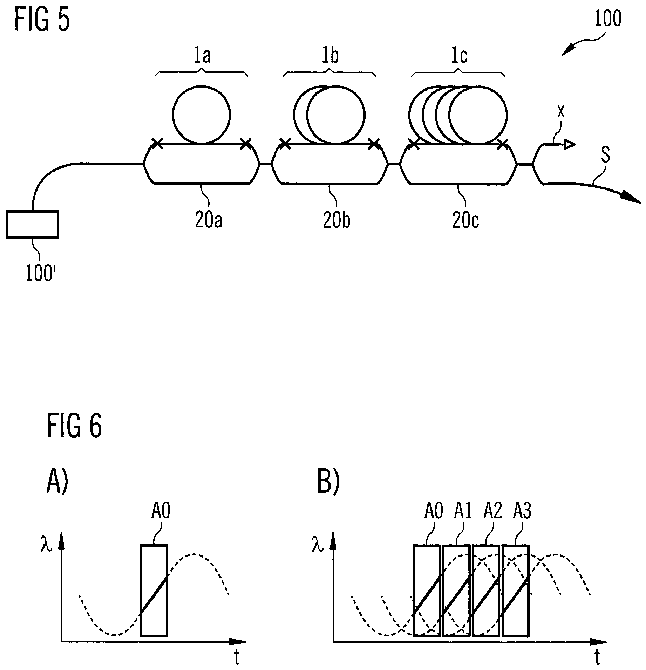

In Figur 5 ist ein Ausführungsbeispiel der Lichtquelle 100 illustriert, bei dem den Verzögerungsstrecken 1a, 1b, 1c jeweils Überbrückungsstrecken 20a, 20b, 20c optisch parallel geschaltet sind. Eine optische Länge der Verzögerungsstrecke 1b beträgt das Doppelte, eine optische Länge der Verzögerungsstrecke 1c das Vierfache der optischen Länge der Verzögerungsstrecke 1a.

Bei dem Teil 100' der Lichtquelle 100 gemäß Figur 5 kann es sich zum Beispiel um eine Lichtquelle gemäß Figur 1 oder gemäß Figur 4 handeln. Auch kann der Teil 100' der Lichtquelle 100 eine spektral gefilterte Breitbandquelle sein. Ebenso ist es möglich, dass der Teil 100' der Lichtquelle 100 ein abstimmbarer Laser mit einem Bandpassfilter ist.

Der Bandpassfilter kann dann ein Fabry-Perot-Filter sein, auf einem rotierenden, schnell winkelveränderlichen Spiegel oder Polygonspiegel basieren, insbesondere in Kombination mit einem dispersiven optischen Element, und/oder ein mikro-elektromechanisches System, kurz MEMS, sein. Weiterhin kann der Teil 100' der Lichtquelle 100 einen Resonator mit einem resonant betriebenen Spiegel mit einem Galvanometerantrieb, insbesondere in Kombination mit einem optisch dispersivem Element, enthalten.

Über eine derart gestaltete Verzögerungsstrecke mit mehreren in Spulen aufgewickelte Teile 1a, 1b, 1c ist eine Abstimmrate der Strahlung S, die von der Lichtquelle 100 emittiert wird, vervielfachbar, gemäß Figur 5 insbesondere verachtfachbar. Optional kann die Lichtquelle 100 einen zweiten Strahlungsausgang X aufweisen. Ferner ist es optional möglich, wie auch bei allen anderen Ausführungsbeispielen, dass die Strahlung S einen in den Figuren nicht gezeichneten Nachverstärker, beispielsweise einen SOA, durchläuft. Es ist hierbei möglich, eine Bestromung des SOAs so einzustellen, dass alle von der Lichtquelle 100 emittierten Lichtimpulse, also sowohl der originäre Lichtimpuls als auch dessen Kopien oder Duplikate, gleiche oder näherungsweise gleiche Intensitäten aufweisen.

In Figur 6 ist ein Prinzip zur Vervielfachung der der Abstimmrate mittels einer Verzögerungsstrecke schematisch illustriert. In den Figuren 6A, 6B ist jeweils die Wellenlänge λ der von der Lichtquelle 100 emittierten Strahlung gegenüber der Zeit t aufgetragen. Gemäß Figur 6A erfolgt eine Emission der Strahlung S nur in dem Zeitfenster A0.

Gemäß Figur 6B wird die Strahlung S in vier Zeitfenstern A0, A1, A2, A3 emittiert. Die Zeitfenster A1, A2, A3 stellen hierbei Kopien oder Duplikate des Lichtimpulses aus dem Zeitfenster A0 dar, hervorgerufen durch ein Durchlaufen der Verzögerungsstrecke der Lichtquelle 100. Ein zeitlicher Verlauf der Wellenlänge λ der Strahlung S ist näherungsweise sägezahnartig.

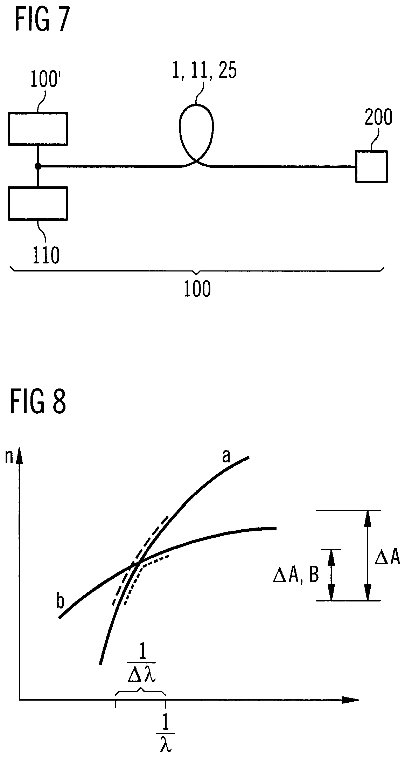

Beim Ausführungsbeispiel der Lichtquelle 100 gemäß Figur 7 ist die Verzögerungsstrecke 1 zum Beispiel durch eine Faser des Typs SMF 28 der Firma Corning gebildet. Die Verzögerungsstrecke 1 stellt gleichzeitig eine optische Übertragungsstrecke 25 dar. In die Verzögerungsstrecke 1 wird Strahlung aus dem Teil 100' und aus dem Teil 110 der Lichtquelle 100 eingekoppelt. Der Teil 100' erzeugt beispielsweise Strahlung um 1050 nm, der Teil 110 Strahlung um 1300 nm, unabhängig von der Strahlung um 1050 nm. Für die Strahlung um 1300 nm stellt die Faser eine Monomodenfaser, für die Strahlung des Teils 100' eine Oligomodenfaser dar. Die Anzahl an Moden, die eine Faser führt, ist von der Wellenlänge der geführten Strahlung abhängig. Somit ist es auch von der Wellenlänge der Strahlung abhängig, ob die Faser eine Monomodenfaser oder eine Oligomodenfaser ist. Eine Detektion der übertragenen Strahlung erfolgt beispielsweise über eine Detektionseinheit 200.

In Figur 8 ist schematisch ein Brechungsindex n der Oligomodenfaser 11 in Abhängigkeit von der Wellenlänge λ der Strahlung S aufgetragen, sowohl für die Grundmode, siehe Kurve b, als auch für die erste höhere Mode, siehe Kurve a. In dem relevanten Wellenlängenbereich, beispielsweise um 1050 nm, ist eine mittlere Steigung der Kurve a größer als eine mittlere Steigung der Kurve b. Ein Brechungsindexunterschied ΔA in dem Abstimmbereich Δλ kann daher, bezogen auf die Kurve a, insgesamt größer sein als der Brechungsindexunterschied ΔA, B, für den Fall, dass sowohl die Grundmode als auch die erste höhere Mode von der Verzögerungsstrecke unterstützt werden. Mit anderen Worten ist es möglich, dass im Falle einer Oligomodenfaser eine chromatische Dispersion geringer ausfällt als im Falle einer Monomodenfaser. Hierdurch kann eine Wellenlängenabstimmgenauigkeit innerhalb der Lichtquelle 100 und damit einhergehend auch eine Effizienzsteigerung der Lichtquelle 100 erzielbar sein.

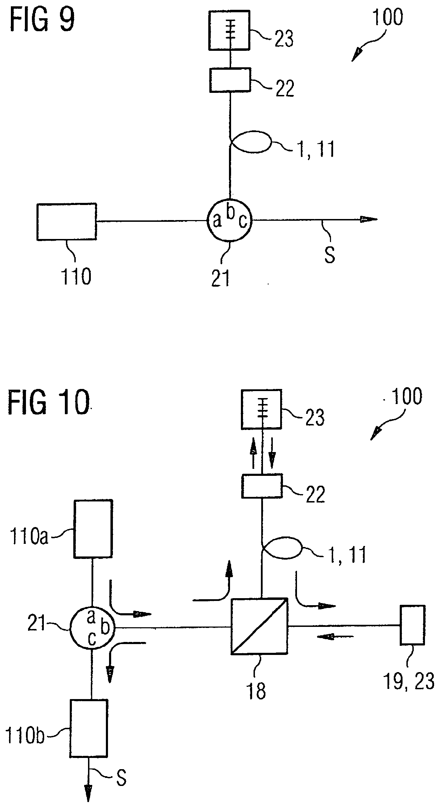

Ein weiteres Ausführungsbeispiel der Lichtquelle 100 ist in Figur 9 dargestellt. Dem Teil 110 der Lichtquelle 100, der zum Beispiel das optische Verstärkermedium enthält, ist ein Zirkulator 21 mit drei Anschlüssen a, b, c nachgeordnet. Licht, das in den Anschluss a des Zirkulators 21 eingestrahlt wird, wird am Anschluss b emittiert. Licht, das den Zirkulator 21 im Anschluss b betritt, wird zum Anschluss c weitergeleitet. Licht, das in den Zirkulator 21 über den Anschluss c eintritt, wird nicht weitergeleitet.

An den Anschluss b schließt sich die Verzögerungsstrecke 1 mit der Oligomodenfaser 11 an. An einem dem Zirkulator 21 abgewandten Ende der Verzögerungsstrecke 1, die optional einen Faraday-Rotator 22 aufweist, befindet sich ein gechirptes Faser-Bragg-Gitter 23, kurz cFBG. Das cFBG 23 ist eine Faser, die entlang einer Hauptpropagationsrichtung einen modulierten Brechungsindex aufweist und hierdurch wie ein Bragg-Spiegel wirkt. Gechirpt bedeutet, dass eine Eindringtiefe in das cFBG 23 für Licht unterschiedlicher Wellenlängen variiert. Abhängig von der Wellenlänge legt das Licht in dem cFBG 23 also unterschiedliche Weglängen zurück. Hierdurch ist eine chromatische Dispersion aufgrund der Oligomodenfaser 11 teilweise oder vollständig kompensierbar.

Gemäß Figur 9 wird die Strahlung S nach Reflexion an dem cFBG 23 und nochmaligem Durchlaufen der Verzögerungsstrecke 1 sowie des Zirkulators 21 emittiert. Abweichend hiervon kann dem Anschluss c des Zirkulators 21 ein weiterer, nicht gezeichneter Teil der Lichtquelle 100 nachgeordnet sein.

Beim Ausführungsbeispiel gemäß Figur 10 befindet sich die Verzögerungsstrecke 1 mit der Oligomodenfaser 11 sowie dem cFBG 23 zwischen den Teilen 110a, 110b der Lichtquelle 100.

Der Faraday-Rotator 22 ist erneut optional. Die Laufrichtung der Strahlung ist durch Pfeile symbolisiert.

Aus dem Teil 110a wird die Strahlung über den Zirkulator 21 hin zu dem polarisationsabhängig reflektierenden Strahlteiler 18 gelenkt. Der Strahlteiler 18 reflektiert die Strahlung hin zu der Verzögerungsstrecke 1, an die das cFBG 23 angeschlossen oder in die das cFBG 23 zur Dispersionskompensation integriert ist. Die Verzögerungsstrecke 1 wird insgesamt zweifach durchlaufen. Anschließend trifft die Strahlung nach Durchgang durch den Strahlteiler 18 auf ein weiteres cFBG 23 oder auf den Spiegel 19 und wird zurück in Richtung zu dem Zirkulator 21 reflektiert. Schließlich gelangt die Strahlung über den Anschluss b zu dem Teil 110b der Lichtquelle 100.

Die hier beschriebene Erfindung ist nicht durch die Beschreibung anhand der Ausführungsbeispiele beschränkt. Vielmehr umfasst die Erfindung jedes neue Merkmal sowie jede Kombination von Merkmalen, was insbesondere jede Kombination von Merkmalen in den Patentansprüchen beinhaltet, auch wenn dieses Merkmal oder diese Kombination selbst nicht explizit in den Patentansprüchen oder Ausführungsbeispielen angegeben ist.

Bezugszeichenliste

| | |
|---|---|
| 100 | wellenlängenabstimmbare Lichtquelle |
| 110 | Teil der Lichtquelle |
| 10 | Resonator/Teilstrecke |
| 1 | Verzögerungsstrecke |
| 3 | optischer Filter |
| 4 | optisches Verstärkungsmedium |
| 11 | Oligomodenfaser |
| 12 | faserbasierter Teil des Resonators |
| 13 | Polarisationscontroller |
| 14 | optischer Koppler |
| 15 | optischer Isolator |
| 16 | Monomodenfaser |
| 17 | Spleiß |
| 18 | Polarisationsabhängig reflektierender Strahlteiler |
| 19 | Spiegel |
| 20 | Überbrückungsstrecke |
| 21 | Zirkulator |
| 22 | Faraday-Rotator |
| 23 | gechirptes Faser-Bragg-Gitter (cFBG) |
| 25 | Übertragungsstrecke |
| 200 | Detektionseinheit |

| | |
|---|---|
| a, b, c | Anschlüsse des Zirkulators |
| A | Aktivitätsfenster |
| D | Armlängendifferenz |
| S | emittierte Strahlung |
| t | Zeit |
| X | Kontrollausgang |
| Y | Signalamplitude |

| | |
|---|---|
| $\lambda$ | Wellenlänge |

**Patentansprüche**

1. Wellenlängenabstimmbare Lichtquelle (100) mit

   - wenigstens einer Faser-basierten Teilstrecke (10) die durch eine Monomodenfaser gebildet wird, und
   - wenigstens einer Verzögerungsstrecke (1),

   wobei die Lichtquelle (100)
   eine periodisch wellenlängenabstimmbare Lichtquelle ist, derart, dass für eine Wellenlänge $\lambda$ zumindest eines Anteils einer von der Lichtquelle (100) emittierten Strahlung (S) in Abhängigkeit von der Zeit t gilt:

   $$\lambda(t) = \lambda(t - \tau)\,,$$

   wobei $\tau$ die Periode der Wellenlängenabstimmung ist, und
   wobei die Verzögerungsstrecke (1) mit zumindest einer Oligomodenfaser (11) gebildet ist, die eine optische Länge von zwischen einschließlich 10 m und 100 km hat und in einem Wellenlängenbereich der von der Lichtquelle (100) emittierten Strahlung (S) dazu eingerichtet ist, zwischen einschließlich 2 Moden und 20 Moden zu führen, wobei

   • die Oligomodenfaser (11) der mindestens einen Verzögerungsstrecke (1) von einem Resonator der Lichtquelle (100) umfasst ist, oder
   • die Oligomodenfaser (11) der mindestens einen Verzögerungsstrecke (1) einem Resonator der Lichtquelle (100) nachgeordnet ist, und der Verzögerungsstrecke (1) eine Überbrückungsstrecke (20) optisch parallel geschaltet ist, wobei eine optische Länge der Überbrückungsstrecke (20) kleiner ist als die optische Länge der Verzögerungsstrecke (1).

2. Lichtquelle (100) nach Anspruch 1,
   bei der mindestens 10 % der Zeitspanne $\tau$ auf eine optische Länge der Verzögerungsstrecke (1) und/oder der Oligomodenfaser (11) zurückgehen.

3. Lichtquelle (100) nach einem der vorhergehenden Ansprüche,
   bei der ein Kerndurchmesser der Oligomodenfaser (11) zwischen einschließlich 7,5 $\mu$m und 9,5 $\mu$m beträgt.

4. Lichtquelle (100) nach einem der vorhergehenden Ansprüche,
   bei der die Verzögerungsstrecke (4) eine optische Länge zwischen einschließlich 100 m und 30 km, vorzugsweise zwischen einschließlich 200 m und 15 km aufweist:

5. Lichtquelle (100) nach einem der vorhergehenden Ansprüche,
   bei der ein Wellenlängenbereich der emittierten Strahlung (S) zwischen einschließlich 950 nm und 1250 nm liegt, und/oder
   bei der eine spektrale Breite eines Abstimmbereichs der im Betrieb emittierten Strahlung (S) mindestens 5 nm und höchstens 300 nm beträgt.

6. Lichtquelle (100) nach einem der vorhergehenden Ansprüche,
   bei der die Oligomodenfaser (11) teilweise oder vollständig aufgerollt ist,
   wobei ein Biegeradius (B) der aufgerollten Oligomodenfaser (11) vorzugsweise zwischen einschließlich 2 cm und 50 cm liegt.

7. Lichtquelle (100) nach einem der vorhergehenden Ansprüche,
   bei der die Verzögerungsstrecke (1) mindestens zwei Spulen mit je einer Oligomodenfaser (11) oder mit je mehreren Oligomodenfasern (11) aufweist, wobeidie Spulen vorzugsweise voneinander verschiedene optische Längen aufweisen, wobei insbesondere eine der Spulen eine optische Länge aufweist, die ein ganzzahliges Vielfaches der optischen Länge der Spule beträgt, die die kleinste optische Länge aufweist.

8. Lichtquelle (100) nach einem der vorhergehenden Ansprüche,
   bei der eine Abstimmrate der im Betrieb emittierten Strahlung (S) mittels der Verzögerungsstrecke (1) vervielfacht ist, indem ein Teil eines Lichtimpulses die Verzögerungsstrecke (1) durchläuft und ein anderer Teil des Lichtimpulses die Verzögerungsstrecke (1) nicht durchläuft.

**9.** Lichtquelle (100) nach einem der vorhergehenden Ansprüche,
bei der die Abstimmrate der Wellenlänge λ der emittierten Strahlung (S) mindestens 1 kHz beträgt, und/oder
bei der ein relativer Zeitanteil, in dem die Lichtquelle (100) im Betrieb im Mittel die Strahlung (S) emittiert, mindestens 1 % beträgt, und/oder
bei der die Verzögerungsstrecke (1) dazu eingerichtet ist, von der im Betrieb emittierten Strahlung (S) mindestens zweifach oder mindestens vierfach durchlaufen zu werden.

**10.** Lichtquelle (100) nach einem der vorhergehenden Ansprüche,
die ein Laser ist.

**11.** Lichtquelle (100) nach einem der vorhergehenden Ansprüche,
bei der
außer der Verzögerungsstrecke (10) alle faserbasierte Teile (12) des Resonators (10) mit Monomodenfasern gestaltet sind.

**12.** Lichtquelle (100) nach einem der vorhergehenden Ansprüche,
die zur Abstimmung der Wellenlänge der im Betrieb zu emittierenden Strahlung (S) einen rotierenden und/oder einen schnell winkelveränderlichen Spiegel enthält, oder die zur Abstimmung der Wellenlänge der im Betrieb zu emittierenden Strahlung (S) einen abstimmbaren Filter, basierend auf einem mikro-elektromechanischen System, enthält, und/oder
bei der eine Wellenlänge der zu erzeugenden Strahlung (S) in einem Wellenlängenbereich zwischen einschließlich 30 % und kleiner 100 % einer Monomodengrenzwellenlänge der Oligomodenfaser (11) liegt.

**13.** Lichtquelle (100) nach einem der vorhergehenden Ansprüche,
die ein Fourier-Domänen-modengekoppelter Laser ist, und/oder die zur optischen Kohärenztomographie eingerichtet ist.

**14.** Lichtquelle nach Anspruch 1, bei der die Faser-basierte Teilstrecke durch einen Faserverstärker, eine Polarisationskontrolleinheit und/oder durch einen Faser-Fabry-Perot-Filter gebildet wird.

**Claims**

**1.** A wavelength tunable light source (100) comprising

- at least one fiber based partial section (10) formed by a single mode fiber and
- at least one delay section (1),

wherein the light source (100) is a periodically wavelength tunable light source, such that
for a wavelength λ of at least one portion of a radiation (S) emitted by the light source (100) as a function of the time t the following relation holds:

$$\lambda(t) = \lambda(t - \tau)$$

wherein τ is the period of the wavelength tuning, and
the delay section (1) is formed with at least one oligomode fiber (11),
which has an optical length that is greater than or equal to 10 m and smaller than or equal to 100 km and which is configured to carry, within a wavelength range of the radiation (S) emitted by said light source (100), between 2 and 20 modes, wherein

- the oligomode fiber (11) of said at least one delay section (1) is comprised by a resonator of the light source (100), or
- the oligomode fiber (11) of said at least one delay section (1) is arranged downstream of a resonator of the light source (100), and a bypass section (20) is connected optically in parallel with the delay section (1), wherein an optical length of said bypass section (20) is smaller than the optical length of the delay section (1).

2. The light source according to claim 1,
wherein at least 10% of the period of time τ is attributed to an optical length of the delay section (1) and/or the oligomode fiber (11).

3. The light source (100) according to any one of the preceding claims,
wherein a core diameter of the oligomode fiber (11) is between 7.5 μm and 9.5 μm inclusive.

4. The light source according to any one of the preceding claims,
wherein the delay section (4) has an optical length of between 100 m and 30 km inclusive, preferably between 200 m and 15 km.

5. The light source (100) according to any one of the preceding claims,
wherein a wavelength range of the radiation (S) emitted during operation is between 950 nm and 1250 nm inclusive, and/or
wherein a spectral width of a tuning range of the radiation emitted during operation is at least 5 nm and at most 300 nm.

6. The light source (100) according to any one of the preceding claims,
wherein the oligomode fiber (11) is partly or completely rolled up,
wherein a bending radius (8) of the rolled up oligomode fiber (11) is at least 2 cm and at most 50 cm.

7. The light source (100) according to any one of the preceding claims,
wherein the delay section (1) comprises at least two coils each having one oligomode fiber (11) or each having a plurality of oligomode fibers (11),
wherein the coils preferably have mutually different optical lengths, and
wherein in particular one of the coils has an optical length which is an integral multiple of the optical length of the coil having the shortest optical length.

8. The light source (100) according to any one of the preceding claims,
wherein a tuning rate of the radiation emitted during operation is multiplied by having a portion of a light pulse passing through the delay section (1) and having another portion of said light pulse not passing through the delay section (1).

9. The light source (100) according to any one of the preceding claims,
wherein the tuning rate of the wavelength λ of the emitted radiation is at least 1 kHz, and/or
wherein a relative time proportion in which the light source emits the radiation on average during operation is at least 1%, and/or
wherein the delay section (1) is arranged such that the radiation emitted during operation passes through it at least twice or at least four times.

10. The light source (100) according to any one of the preceding claims,
which is a laser.

11. The light source (100) according to any one of the preceding claims,
wherein, apart from the delay section (10), all fiber based parts (12) of the resonator are fashioned with single mode fibers.

12. The light source (100) according to any one of the preceding claims,
which contains a rotating and/or a rapidly angle variable mirror for tuning the wavelength of the radiation (S) to be emitted during operation, or
which contains a tunable filter, based on a microelectromechanical system, for tuning the wavelength of the radiation (S) to be emitted during operation, and/or
wherein the wavelength to be generated is in the wavelength range of between 30% and less than 100% inclusive of the single mode cut off wavelength of the oligomode fiber (11).

13. The light source (100) according to any one of the preceding claims,
wherein the light source is a Fourier domain mode locked laser, and/or
which is designed for optical coherence tomography.

**14.** The light source (100) according to any one of the preceding claims,
wherein the fiber based partial section is formed by a fiber amplifier, by a polarization control unit and/or by a fiber Fabry-Pérot filter.

**Revendications**

**1.** Source lumineuse (100) à longueur d'onde accordable, avec

- au moins un tronçon partiel (10) à base de fibre qui est formé par une fibre monomode, et
- au moins un tronçon de retard (1),

la source lumineuse (100)
étant une source lumineuse à longueur d'onde accordable périodiquement de telle sorte que, pour une longueur d'onde λ d'au moins une fraction du rayonnement (S) émis par la source lumineuse (100) en fonction du temps t, on a :

$$\lambda(\tau) = \lambda(t-\tau),$$

$\tau$ étant la période de l'accord de longueur d'onde, et
le tronçon de retard (1) étant formé avec au moins une fibre oligomode (11) qui a une longueur optique entre 10 m et 100 km inclus et qui, dans une plage de longueur d'onde du rayonnement (S) émis par la source lumineuse (100), est agencée pour conduire entre 2 modes et 20 modes inclus,

- la fibre oligomode (11) du tronçon de retard (1) au moins au nombre de un est englobée par un résonateur de la source lumineuse (100), ou
- la fibre oligomode (11) du tronçon de retard (1) au moins au nombre de un est subordonnée à un résonateur de la source lumineuse (100), et un tronçon de pontage (20) est monté de façon optiquement parallèle au tronçon de retard (1), une longueur optique du tronçon de pontage (20) étant plus petite que la longueur optique du tronçon de retard (1).

**2.** Source lumineuse (100) selon la revendication 1,
dans laquelle au moins 10 % du laps de temps $\tau$ sont attribués à une longueur optique du tronçon de retard (1) et/ou de la fibre oligomode (11).

**3.** Source lumineuse (100) selon l'une des revendications précédentes,
dans laquelle un diamètre d'âme de la fibre oligomode (11) est compris entre 7,5 $\mu$m et 9,5 $\mu$m inclus.

**4.** Source lumineuse (100) selon l'une des revendications précédentes,
dans laquelle le tronçon de retard (4) présente une longueur optique entre 100 m et 30 km inclus, de préférence entre 200 m et 15 km inclus.

**5.** Source lumineuse (100) selon l'une des revendications précédentes,
dans laquelle une plage de longueur d'onde du rayonnement (S) émis est comprise entre 950 nm et 1250 nm inclus, et/ou
dans laquelle une largeur spectrale d'une plage d'accord du rayonnement (S) émis pendant le fonctionnement est égale à 5 nm au moins et à 300 nm au plus.

**6.** Source lumineuse (100) selon l'une des revendications précédentes,
dans laquelle la fibre oligomode (11) est enroulée partiellement ou totalement, un rayon de courbure (B) de la fibre oligomode (11) enroulée étant de préférence compris entre 2 cm et 50 cm inclus.

**7.** Source lumineuse (100) selon l'une des revendications précédentes,
dans laquelle le tronçon de retard (1) présente au moins deux bobines avec chacune une fibre oligomode (11) ou avec chacune plusieurs fibres oligomodes (11), les bobines présentant de préférence des longueurs optiques différentes les unes des autres, en particulier une des bobines présentant une longueur optique qui est un multiple entier de la longueur optique de la bobine qui présente la longueur optique la plus petite.

**8.** Source lumineuse (100) selon l'une des revendications précédentes, dans laquelle une fréquence d'accord du rayonnement (S) émis pendant le fonctionnement est multipliée au moyen du tronçon de retard (1) par le fait qu'une partie de l'impulsion lumineuse traverse le tronçon de retard (1) et une autre partie de l'impulsion lumineuse ne traverse pas le tronçon de retard (1).

**9.** Source lumineuse (100) selon l'une des revendications précédentes, dans laquelle la fréquence d'accord de la longueur d'onde λ du rayonnement (S) émis est d'au moins 1 kHz, et/ou dans laquelle une fraction de temps relative pendant laquelle la source lumineuse (100) émet pendant le fonctionnement en moyenne le rayonnement (S) est au moins égale à 1 %, et/ou dans laquelle le tronçon de retard (1) est agencé pour être parcouru au moins deux fois ou au moins quatre fois par le rayonnement (S) émis pendant le fonctionnement.

**10.** Source lumineuse (100) selon l'une des revendications précédentes, laquelle est un laser.

**11.** Source lumineuse (100) selon l'une des revendications précédentes, dans laquelle, en dehors du tronçon de retard (10), toutes les parties à base de fibre (12) du résonateur (10) sont constituées avec des fibres monomodes.

**12.** Source lumineuse (100) selon l'une des revendications précédentes qui, pour l'accord de la longueur d'onde du rayonnement (S) à émettre pendant le fonctionnement, contient un miroir rotatif et/ou un miroir dont l'angle peut être modifié rapidement ou qui, pour l'accord de la longueur d'onde du rayonnement (S) à émettre pendant le fonctionnement, contient un filtre accordable, basé sur un système micro-électromécanique, et/ou dans laquelle une longueur d'onde du rayonnement (S) à produire se situe dans une plage de longueur d'onde entre 30 % inclus et moins de 100 % d'une longueur d'onde limite monomode de la fibre oligomode (11).

**13.** Source lumineuse (100) selon l'une des revendications précédentes, laquelle est un laser à couplage de mode dans le domaine de Fourier, et/ou laquelle est agencée pour la tomographie en cohérence optique.

**14.** Source lumineuse selon la revendication 1, dans laquelle le tronçon partiel à base de fibre est formé par un amplificateur à fibre, une unité de contrôle de polarisation et/ou par un filtre Fabry-Perot à fibre.

FIG 1

FIG 2

FIG 3

FIG 4

FIG 5

FIG 6

A)

B)

# FIG 7

# FIG 8

## FIG 9

100

23

22

1, 11

110

a b c

21

S

## FIG 10

100

23

22

1, 11

110a

21

a b c

18

19, 23

110b

S

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 2006187537 A1
- US 5077815 A
- US 5416862 A
- WO 2008135034 A1

- EP 1271194 A2
- DE 19926299 A1
- US 20060072632 A1


**In der Beschreibung aufgeführte Nicht-Patentliteratur**

- **PALTE G et al.** Fourier domain mode locked (FDML) lasers for polarization sensitive OCT. *PROCEEDINGS OF THE SPIE,* 17. Juni 2009, vol. 7372
- **D. GLOGE.** *Weakly Guiding Fibers, Applied Optics,* 1971, vol. 10 (10), 2252-2258

- Single transverse mode optical resonators. *Optics Express,* 10. Januar 2005, vol. 13 (1), 171-181
- High-speed wavelength-swept semiconductor laser with a polygon-scanner-based wavelength filter. *Optics Letters,* 15. Oktober 2003, vol. 28 (20), 1981-1983